Europäisches Patentamt

European Patent Office

Office européen des brevets

(11) Publication number: **0 034 241**
**B1**

(12) EUROPEAN PATENT SPECIFICATION

(45) Date of publication of patent specification: 09.10.85

(51) Int. Cl.⁴: H 03 H 17/06

(21) Application number: 81100053.8

(22) Date of filing: 07.01.81

(54) Non-recursive digital filter.

(30) Priority: 07.01.80 JP 404/80

(43) Date of publication of application:
26.08.81 Bulletin 81/34

(45) Publication of the grant of the patent:
09.10.85 Bulletin 85/41

(84) Designated Contracting States:
DE FR GB NL

(56) References cited:
US-A-4 215 415

IEEE TRANSACTIONS ON COMMUNICATIONS,
vol. COM-2,3, no. 2, February 1975, NEW
YORK; US, P. VAN GERWEN et al.: "A new type
of digital filter for data transmission", pages
222-234

(73) Proprietor: NEC CORPORATION
33-1, Shiba 5-chome, Minato-ku
Tokyo 108 (JP)

(72) Inventor: Nakayama, Kenji
c/o Nippon Electric Co., Ltd. 33-1, Shiba
Gochome
Minato-ku Tokyo (JP)

(74) Representative: Vossius Vossius Tauchner
Heunemann Rauh
Siebertstrasse 4 P.O. Box 86 07 67
D-8000 München 86 (DE)

## Description

The present invention relates to a non-recursive digital filter and, more particularly, to a non-recursive digital filter designed to use differences in filter coefficients between adjacent multipliers as new coefficients.

A digital filter is a device to perform the digital operation for a binary coded word (codeword) sequence obtained through the analog to digital (A/D) conversion of an analog signal such a speech signal so as to produce desired filtering characteristics such as frequency or delay characteristics.

In general, each of the digital filters is classified into either a recursive filter (R-filter) having a feedback loop or a non-recursive filter (NR-filter) having no feedback loop. One example of such an R-filter is disclosed in the U.S. Patent No. 4,215,415. This filter achieves the desired filtering characteristics by connecting second-order filtering sections in a cascade form. However, the R-filter cannot be used as a filter for achieving a linear-phase characteristics, which are indispensable to the well-known VSB (vestigial side band) transmission system for television broadcasting or the like.

Such an NR-filter, on the other hand, can be used in a MODEM (modulator and demodulator), an echo canceller, or a like device, because the filter enables achieving a wide range of linear-phase and/or delay characteristics. To realize steep filtering characteristics, however, this filter requires a considerable number of multipliers, resulting in an expensive, complicated device.

For these reasons, an improved NR-filtering device has been proposed in a paper entitled "A New Type of Digital Filter for Data Transmission", by Fred A. M. Snijders et al., IEEE Transactions of Communications, Vol. COM-23, No. 2, February issue, 1975, pp. 222—234.

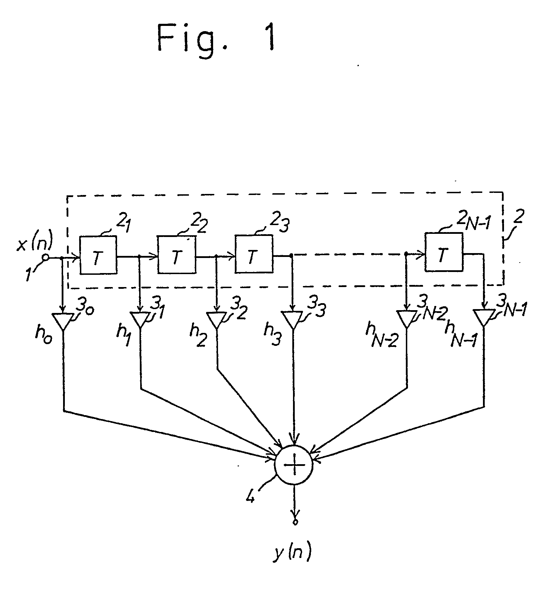

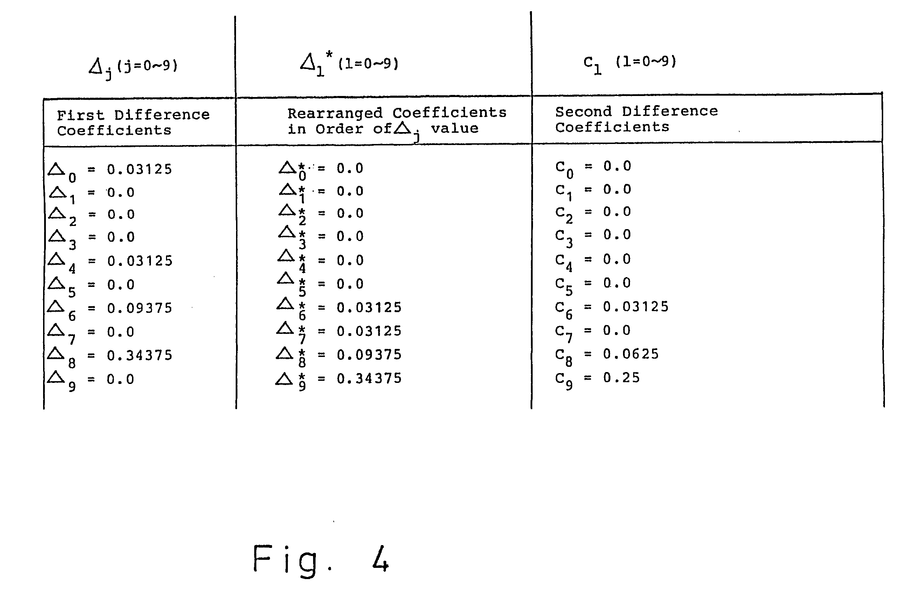

The device illustrated in Figure 4 on page 224 of this article is a cascade of an NR-filter and a R-filter. The NR-filter part is similar to the device shown in figure 1 of this specification and is designed to use a restricted set of filter coefficients in the multipliers and an integrator, for integrating the output of the NR-filter. Such a filter, however, tends to oscillate, deteriorating the desired filtering characteristics, because the gain of the feedback loop used in the integrator is set at an absolute value of 1. The setting of the feedback loop gain at an integer consequently restricts the filtering characteristics to be achieved.

One object of the present invention, therefore, is to provide an improved NR-filter capable of achieving the desired filtering characteristics through a relatively small number of operations.

According to one aspect of the invention, there is provided a non-recursive digital filter having N predetermined filter coefficients $h_i$ (i=0 to N−1) to perform

$$y(n) = \sum_{i=0}^{N-1} h_i x(n-i) = \sum_{i,j=0}^{N-1} \text{sign}(h_i) h^*_j x^*(n-j) = \sum_{j=0}^{N-1} h^*_j \widetilde{x}^*(n-j) = \sum_{j=0}^{N=1} \Delta_j u(n-j)$$

in response to a sequence $x(n-i)$ of N consecutive binary codewords, where $h^*_j$ represent the absolute values of the coefficients $h_i$ arranged in the order of magnitude so that each index j is in one-to-one correspondence with a specific index i; $x^*(n-j)$ represent $x(n-i)$ corresponding to $h^*_j$; sign $(h_i)$ represent the polarities of $h_j$; $\Delta_j$ represent differences between adjoining coefficients $h^*_j$; $\widetilde{x}^*(n-j)$ represent the products of sign $(h_i)$ and the corresponding $x^*(n-j)$; and

$$u(n-j) = \sum_{k=j}^{N-1} \widetilde{x}^*(n-k).$$

This claimed filter preferably and non-limitingly comprises:

arranging means for arranging said sequence $x(n-i)$ corresponding to the coefficients $h^*_j$ to obtain $x^*(n-j)$; first means for obtaining the product of each of the outputs $x^*(n-j)$ given from the arranging means and the corresponding polarity of each of the coefficients $h_i$; second means for accumulating the outputs $\widetilde{x}^*(n-j)$ given from said first means to obtain $u(n-j)$ and coefficient generating means for producing said differences $\Delta_j$; third means for multiplying the outputs $u(n-j)$ supplied from said second means by said differences $\Delta_j$; and fourth means for accumulating the outputs $\Delta_j u(n-j)$ given from said third means.

According to another aspect of the invention, there is provided a non-recursive digital filter having predetermined N filter coefficients $h_i$(i=0 to N−1) to perform

$$y(n) = \sum_{i=0}^{N-1} h_i x(n-i) = \sum_{i,j=0}^{N-1} \text{sign}(h_i) h^*_j x^*(n-j) = \sum_{j=0}^{N-1} h^*_j \widetilde{x}^*(n-j) = \sum_{j=0}^{N=1} \Delta_j u(n-j) = \sum_{l=0}^{N-1} C_l u(n-l)$$

in response to a sequence $x(n-i)$ of N consecutive binary coded words, where $C_l$ represent differences between adjoining coefficients $\Delta_i^*$ obtained by arranging $\Delta_j$ in the order of magnitude;

2

$$u(n-l)= \sum_{k=l}^{N-1} u^*(n-k);$$

and $u^*(n-l)$ represent $u(n-j)$ corresponding to $\Delta_l^*$ (remaining terms correspond to those previously explained).

This claimed filter preferably and non-limitingly comprises:

first arranging means for arranging said sequence $x(n-i)$ corresponding to the coefficients $h^*_j$ to obtain $x^*(n-j)$; first arithmetic means for obtaining the product each of outputs $x^*(n-j)$ given from the first arranging means and the corresponding polarity of each of the coefficients $h_i$; first adding means for accumulating the outputs $\widetilde{x}^*(n-j)$ given from the first arithmetic means to obtain $u(n-j)$; second arranging means for arranging the outputs $u(n-j)$ supplied from said first adding means corresponding to the coefficients $\Delta_l^*$ to produce $u^*(n-l)$; second adding means for accumulating the outputs fed from the second arranging means to obtain $u(n-l)$ and coefficient generating means for producing said coefficients $C_l$; second arithmetic means for multiplying the outputs $u(n-l)$ supplied from the second adding means by said coefficients $C_l$; and third adding means for accumulating the outputs $C_l u(n-l)$ given from the second arithmetic means.

The invention will be described in greater detail in conjunction with the accompanying drawings, wherein:

Figure 1 shows a conventional NR-filter;

Figure 2 shows a block diagram illustrating a first embodiment of the invention;

Figures 3 and 4 show tables showing examples of filter coefficients;

Figure 5 shows a block diagram illustrating a second embodiment of the invention; and

Figures 6(a) to (t) are time charts for describing the operation of the filter shown in Figure 5.

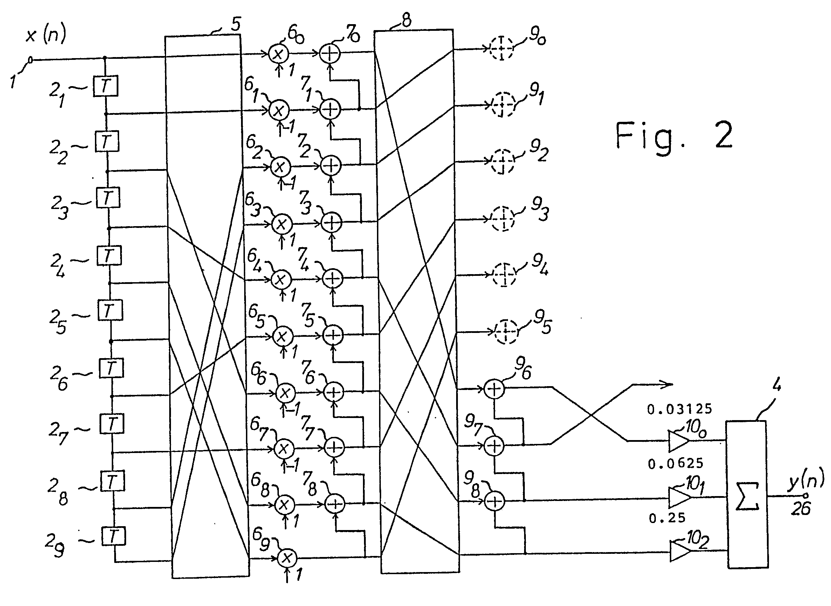

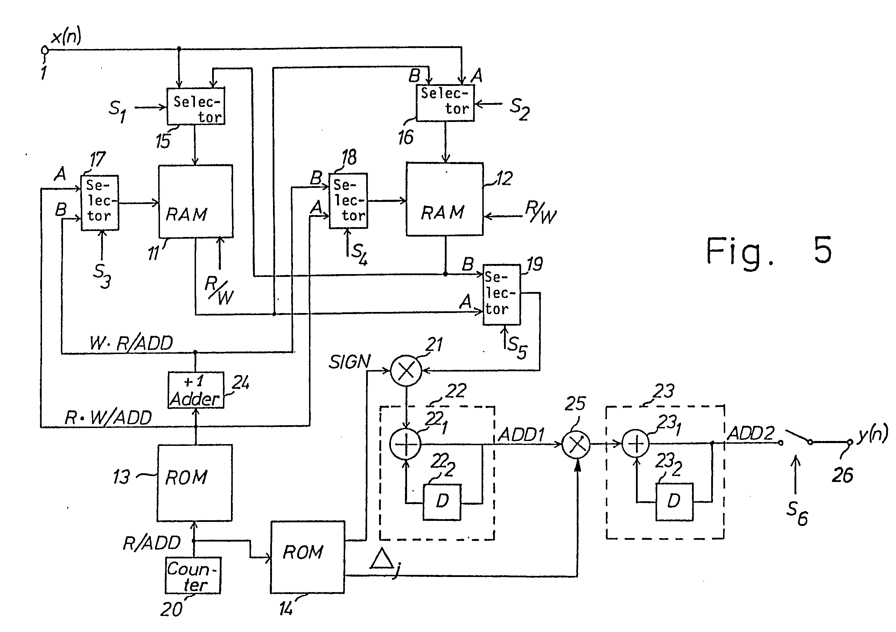

In the drawings, the same reference numerals represent the same structural elements. It is to be noted that serial or parallel bits are supplied to signal paths shown in Figure 2, whereas parallel bits alone, except control signals, are supplied to those shown in Figure 5.

Referring to Figure 1, a sequence $x(n)$ consisting of a plurality of codewords (of 16 bits per word) obtained through the A/D conversion of an analog signal at a sampling frequency $F_s$ is supplied to an input terminal 1. The sequence $x(n)$ is given to a delay device 2 composed of $N-1$ delay elements $2_1$ through $2_{N-1}$, each having a delay time T equal to the sampling period $1/F_s$. The outputs $x(n)$ to $x(n-N+1)$ of the delay elements $2_1$ through $2_{N-1}$ are sent to multipliers $3_0$ through $3_{N-1}$, each having a corresponding filter coefficient $h_i(i=0, 1, \ldots, N-1)$ derived from a desired impulse response or frequency transfer function. The outputs of the multipliers $3_0$ through $3_{N-1}$ are sent to an adder 4 to give an output codeword sequence $y(n)$. Such structure allows the achievement of the required filtering characteristics by appropriately varying the coefficients $h_i$.

Next, the process to derive the algorithm of the filtering operation employed in the present invention will be described in more detail. Differential formula representing the filtering operation of Figure 1 in the time domain can be expressed as follows:

$$y(n)= \sum_{i=0}^{N-1} h_i x(n-i) \qquad (1)$$

where N is the number of traps of the delay elements used, $x(n-i)$ is codeword at time $(n-i)$, and $h_i$ are filter coefficients (referred to hereunder as "coefficients") derived from the impulse response of the filter. The codewords taken out of the terminals of the delay elements $2_1$ through $2_{N-1}$ are $x(n)$ to $x(n-N+1)$.

Generally, a binary codeword may be expressed based on either signed-magnitude representation using a sign bit indicating the polarity (or sign) of the original analog signal and absolute value bits representing the magnitude of the signal or by signed-2's-complement representation (for details of these representations, see Digital computer Design Fundamentals published in 1962 by McGraw-Hill Book Company, Inc., pp. 10—15). It is assumed now that the coefficient $h_i$ are represented by the sign-magnitude representation and the codewords $x(n-i)$ are represented by the two's complement representation.

Also, supposing that the absolute values of the coefficients $h_i(h_0$ to $h_{N-1})$ are arranged in the ascending order of magnitude as coefficients $h^*_j(j=0$ to $N-1)$, and $x(n-i)[x(n)$ to $x(n-N+1)]$ are arranged corresponding to $h^*_j$ as $x^*(n-j)$, equation (1) will be rewritten as follows:

$$h^*_j= |h_i|, \quad h^*_0 \leqq h^*_1 \leqq h^*_2 \leqq \ldots \leqq h^*_{N-1}$$

$$y(n)= \sum_{i,j=0}^{N-1} \text{sign}(h_i) h^*_j x^*(n-j) \qquad (2)$$

where $\text{sign}(h_i)$ indicate the signs of $h_i$, each of which has a value of either 1 or $-1$.

Assuming now that the products of the signs of the coefficients $h_i$ and $x^*(n-j)$ are represented by $\widetilde{x}^*(n-j)$, equation (2) can be transformed as follows:

3

$$y(n) = \sum_{j=0}^{N-1} h_j^* \tilde{x}^*(n-j) \qquad (3)$$

Next, differences $\Delta_j$ between adjoining coefficients $h_j^*$ and $h_{j-1}^*$ will be expressed as follows:

$$\Delta_j = h_j^* - h_{j-1}^*, \quad j=0, 1, \ldots N-1 \qquad (4)$$

$$h_{-1}^* = 0$$

Here, the sum of all the codewords rearranged from the j-th through the (N−1)-th can be expressed by:

$$u(n-j) = \sum_{k=j}^{N-1} \tilde{x}^*(n-k) \qquad (5)$$

By the substitution of equations (4) and (5) into equation (3), the following equation (6) can be obtained:

$$y(n) = \sum_{j=0}^{N-1} \Delta_j u(n-j) \qquad (6)$$

The values of $u(n-j)$ in equation (5) are obtained from the following equations (7) and (8):

$$u(n-j) = u(n-j-1) + \tilde{x}^*(n-j) \qquad (7)$$

$$j=0, 1, \ldots, N-2$$

$$u(n-N+1) = \tilde{x}^*(n-N+1) \qquad (8)$$

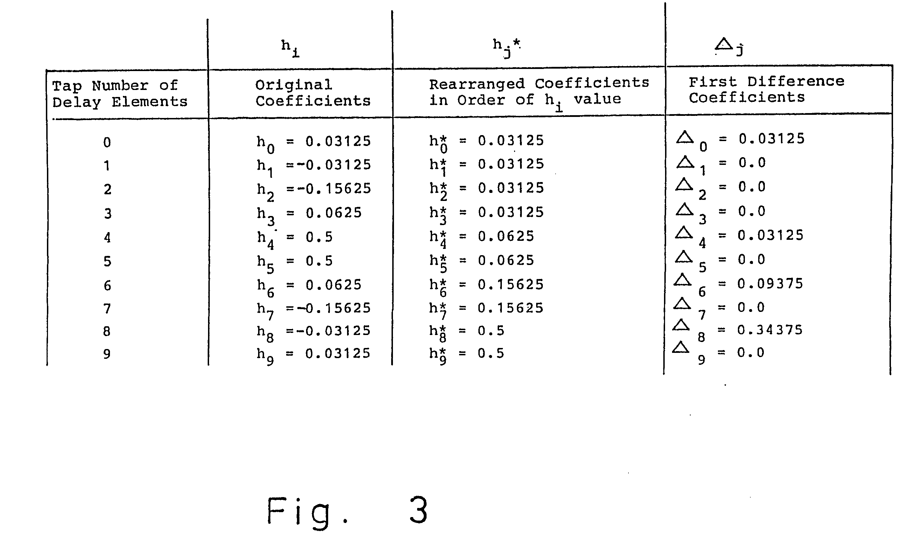

Equation (1) representing the sum of each of the products of the coefficients $h_i(h_i$ to $h_{N-1})$ and the codewords $x(n-i)[x(n)$ to $x(n-N+1)]$ as indicated by equation (6) can be converted into the sum of each of the products of the coefficient differences $\Delta_0$ to $\Delta_{N-1}$ and the codewords $u(n)$ to $u(n-N+1)$. Since the coefficient differences $\Delta_0$ to $\Delta_{N-1}$ include some zeros as shown in Figure 3, the total number of the operations required in equation (6) is less than that in equation (1).

For further reduction of the number of the operations required in equation (6), the coefficients $\Delta_0$ to $\delta_{N-1}$ in equation (6) are arranged in the ascending order of magnitude as $\Delta_1^*$, and as a result, each of the differences between adjoining coefficients $\Delta_1^*$ to $\Delta_{1-1}^*$ become $C_l$. Therefore, the following equation (9) is obtained:

$$C_l = \Delta_1^* - \Delta_{l-1}^* \qquad (9)$$

$$\Delta_{-1}^* = 0$$

Also, assuming that $u(n-j)$ corresponding to the arranged coefficients $\Delta_1^*$ are $u^*(n-l)$ and the sum of the codewords arranged from the l-th through the (N−1)-th is $u(n-l)$, equation (6) can be rewritten by the use of both $u(N-n-l)$ and equation (9) as follows:

$$y(n) = \sum_{l=0}^{N-1} C_l u(n-l) \qquad (10a)$$

$$u(n-l) = \sum_{k=l}^{N-1} u^*(n-k) \qquad (10b)$$

The values of $u(n-l)$ in equation (10b) are obtained from equations (7) and (8) as follows:

$$u(n-l) = u(n-l-1) + u^*(n-l) \qquad (11)$$

$$l=0, 1, \ldots, N-2$$

$$u(n-N+1) = u^*(n-N+1) \qquad (12)$$

**0 034 241**

Because the coefficients $C_0$ to $C_{N-1}$ representing the differences in the coefficients $\Delta^*_0$ to $\Delta^*_{N-1}$ in equation (9) are virtually zero (see Figure 4 to be referred to hereunder), the number of the operations required can be substantially reduced, compared with the calculation by equation (1).

Referring to Figure 2, a first embodiment is designed to perform the filtering operations expressed by equations (10) through (12). The Figure 2 filter functions as a low-pass filter whose multiplication coefficients $h_0$ to $h_9$ have the values of the original coefficients shown in Figure 3. Referring to Figure 2, a codeword sequence $x(n)$ is fed to delay elements $2_1$ through $2_9$, each having a delay time equal to the sampling period $1/F_s$. The outputs $x(n)$ to $x(n-9)$ of the delay elements $2_1$ through $2_9$ are sent to a first arranging circuit 5. As a result, the codewords $x(n)$ to $x(n-9)$ are arranged corresponding to the coefficients $h^*_0$ to $h^*_9$ depending on the arrangement of the absolute values of the original coefficients $h_0$ to $h_9$ shown in Figure 3. For instance, a coefficient $h_2=-0.15625$ corresponding to the codeword $x(n-2)$ taken out of the second delay element $2_2$ (the second tap) corresponds to the sixth coefficient $h^*_6$, so that the codeword $x(n-2)$ fed to the second input terminal of the circuit 5 is taken out as $x^*(n-6)$ from the sixth output terminal of the circuit 5. The circuit 5 shown in Figure 2 is designed to have the shown wire connection to produce $x^*(n)$ to $x^*(n-9)$. Each of the outputs of the circuit 5 is multiplied by the corresponding sign of each of the coefficients $h_0$ to $h_9$ at multipliers $6_0$ through $6_9$ so as to give $\widetilde{x}^*(n-j)$. The multiplication by 1 or $-1$ may be achieved by an Exclusive OR circuit. The outputs of the multipliers $6_0$ through $6_9$ are fed to adders $7_0$ through $7_9$, so that

$$u(n-j)= \sum_{k=j}^{N-1} \widetilde{x}^*(n-k)$$

shown in equation (5) may be calculated. The outputs of the adders $7_0$ through $7_9$ are given to a second arranging circuit 8. The outputs $u(n-j)$ of the adders $7_0$ through $7_9$ are arranged corresponding to the differences between adjoining ones in the arranged coefficients $\Delta^*_i$ depending on the arrangement of coefficients $\Delta_i$ in the order of magnitude. For instance, since a coefficient $\Delta_0=0.03125$ corresponding to the output of the adder $7_0$ corresponds to the sixth coefficient $\Delta^*_6$, the output of the adder $7_0$ fed to the 0-th terminal of the circuit 8 is taken out from the 6-th terminal of the circuit 8. The outputs of the circuit 8 are given to adders $9_6$ through $9_8$ to give $u(n-l)$. It is to be noted that adders $9_0$ through $9_5$ may be omitted, because $\Delta^*_0$ to $\Delta^*_5$ out of the coefficients $\Delta^*_i$ are zero. The outputs of the adders $9_6$ through $9_8$ are multiplied by $C_6$, $C_8$, and $C_9$ at multipliers $10_0$, $10_1$, and $10_2$, respectively. Since the coefficients $C_0$ to $C_5$ and $C_7$ are zero, no more than three multipliers are needed. The outputs of the multipliers $10_0$, $10_1$, and $10_2$ are given to an adder 4. The output of the adder 4 is taken out from an output terminal 26 as an output $y(n)$. This embodiment thus requires only three multipliers to achieve a substantial reduction in the number of the operations compared with the conventional Figure 1 filter using ten multipliers.

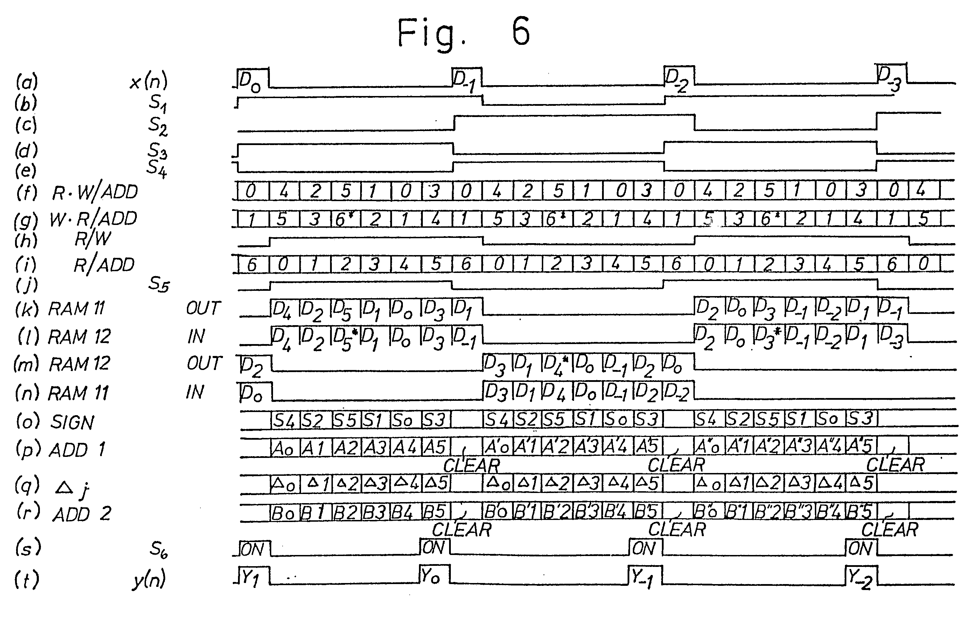

Referring to Figure 5, a second embodiment is designed to perform the filtering operations expressed by equations (6) through (8). These operations will be described referring to Figure 5 and Figures 6(a) to (t). It is assumed now that, in equation (1), the number of the delay elements used is 5, the number of the coefficients $h_i$ is 6

$$( \mid h_3 \mid \leqq \mid h_0 \mid \leqq \mid h_1 \mid \leqq \mid h_5 \mid \leqq \mid h_2 \mid \leqq \mid h_4 \mid ),$$

and the codewords taken out of the delay elements are $D_0$ to $D_5$. The input codewords are arranged as codewords $D_4$, $D_2$, $D_5$, $D_1$, $D_0$, and $D_3$ corresponding to the coefficients $h^*_0$ to $h^*_5$ depending on the arrangement of the coefficients $h_0$ to $h_5$ in the order of absolute values of magnitude. This arrangement is made by the use of random access memories (RAMs) 11 and 12, selectors 15—19, a plus-one-adder 24, read only memory (ROM) 13, and a counter 20. It is noted that each of the RAMs 11 and 12 performs the read-out or write-in operation in response to a control signal R/W shown in Figure 6(h). A plurality of codewords $D_0$ to $D_5$ are written through the selector 15 into addresses 0 through 5 of the RAM 11 in response to write-in address signals given by the ROM 13. Reading out of the ROM 13 and a ROM 14 to be referred to below, is achieved in response to a read-out address (R/ADD) given from the counter 20 (see Figure 6(i)). In this state, each of the selectors 16 and 18 selects its terminal B in response to the low level ("0") of control signals $S_2$ and $S_4$ (Figures 6(c) and (e)), and each of the selectors 17 and 19 selects its terminal A in response to the high level ("1") of control signals $S_3$ and $S_5$ (Figures 6(d) and (j)). Next, the content of the RAM 11 is read out in response to a read-out address $R \cdot W/ADD$ for the arrangement given from the ROM 13 through the terminal A of the selector 17 so as to produce the outputs $x^*(n-j)$ to a multiplier 21. Since there is a relationship of

$$\mid h_3 \mid \leqq \mid h_0 \mid \leqq \mid h_1 \mid \leqq \mid h_5 \mid \leqq \mid h_2 \mid \leqq \mid h_4 \mid$$

for the coefficients $h_0$ to $h_5$, the arrangement address $R \cdot W/ADD$ for the codewords $D_0$ to $D_5$ is so set as to read out in the order of $D_4$, $D_2$, $D_5$, $D_1$, $D_0$, and $D_3$ as shown in Figure 6(f).

Of these codewords read out from the RAM 11 (Figure 6 (k)), $D_0$ to $D_4$ stored at the 0-th through the 4-th addresses are written through the terminal B of the selector 16 into the first through the fourth addresses of

5

the RAM 12 (Figure 6(I)) in response to a write-in address $W \cdot R/ADD$ (Figure 6(g)) given through the terminal B of the selector 18 from the ROM 13. The write-in address is produced by adding 1 to a read-out address given to the adder 24 from the ROM 13. In Figure 6(I), the codeword $D_5$, which is not stored in the RAM 12, is expressed as $D^*_5$.

Codewords $D_4$, $D_2$, $D_5$, $D_1$, $D_0$, and $D_3$ corresponding to $x^*(n-j)$ read out of the RAM 11 are given to the multiplier 21 through the terminal A of the selector 19, so that they are multiplied by the corresponding sign bits (Figure 6(o)) of the coefficients $h^*_j$ corresponding to $x^*(n-j)$, which are read out of the ROM 14. The consequent outputs $\tilde{x}^*(n-j)$ of the multiplier 21 are given to a first accumulator 22 consisting of a delay element $22_2$ and an adder $22_1$. As a result, the calculations $u(n)$ to $u(n-5)$ defined in equation (5) are made, $u(n)$ to $u(n-5)$ are represented as $A_0$ to $A_5$ in Figure 6 (p), which have the following relationship:

| u(n−j), where j=0 to 5 | |
|---|---|
| $u(n-5)=A_0=S_4D_4$ | $u(n-2)=A_3=A_2+S_1D_1$ |
| $u(n-4)=A_1=A_0+S_2D_2$ | $u(n-1)=A_4=A_3+S_0D_0$ |
| $u(n-3)=A_2=A_1+S_5D_5$ | $u(n)=A_5=A_4+S_3D_3$ |

The outputs $A_0$ to $A_5$ of the first accumulator 22 and the coefficients $\Delta_j$ ($\Delta_0$ to $\Delta_5$) (Figure 6(g)) read out of the ROM 14 are multiplied by each other in a multiplier 25 to calculate $\Delta_j u(n-j)$, that is, $B_0$ to $B_5$ (Figure 6(r)). The outputs $B_0$ to $B_5$ of the multiplier 25 are accumulated by a second accumulator 23 consisting of a delay element $23_2$ and an adder $23_1$. The outputs $B_0$ to $B_5$ of Figure 6(r) are as follows:

| $\Delta_j (j=0 \text{ to } 5)$ | $\Delta_j u(n-j)$ (j=0 to 5) |
|---|---|
| $\Delta_0 = \mid h_r \mid - \mid h_2 \mid$ | $\Delta_0 u(n-5)=B_0=\Delta_0 A_0$ |
| $\Delta_1 = \mid h_2 \mid - \mid h_5 \mid$ | $\Delta_1 u(n-4)=B_1=B_0+\Delta_1 A_1$ |
| $\Delta_2 = \mid h_5 \mid - \mid h_1 \mid$ | $\Delta_2 u(n-3)=B_2=B_1+\Delta_2 A_2$ |
| $\Delta_3 = \mid h_1 \mid - \mid h_0 \mid$ | $\Delta_3 u(n-2)=B_3=B_2+\Delta_3 A_3$ |
| $\Delta_4 = \mid h_0 \mid - \mid h_3 \mid$ | $\Delta_4 u(n-1)=B_4=B_3+\Delta_4 A_4$ |
| $\Delta_5 = \mid h_3 \mid$ | $\Delta_5 u(n)=B_5=B_4+\Delta_5 A_5$ |

The output of the accumulator 23 is taken out as the filtering output $y(n)$ through a switch 26, which operates in response to a control signal $S_6$ (Figure 6(s)). Upon completion of the filtering operation of one codeword, the accumulators 22 and 23 are cleared, and the selectors 16 and 18 select their terminals A in response to "1" of the control signals $S_2$ and $S_4$, while the selectors 17 and 19 select their terminals B. Simultaneously, for the filtering operation for the next codeword, the codeword $D_{-1}$ is written into the 0-th address of the RAM 12 through the input terminal 1. Similarly, the codewords $D_{-1}$, $D_0$, $D_1$, $D_2$, $D_3$, and $D_4$ are read out of the RAM 12 in response to the arrangement address $R \cdot W/ADD$ to obtain $x^*(n-j)$ (Figure 6(m)), and at the same time, other codewords than $D_4$, i.e., codewords $D_{-1}$ to $D_3$, are stored in the RAM 11 (Figure 6(n)). Then, the multiplications by the sign bits (Figure 6(o)) are achieved in the multiplier 21, and further the values of $u(n-j)$, $\Delta_j u(n-j)$, and

$$y(n)= \sum_{j=0}^{N-1} \Delta_j u(n-j)$$

are obtained from the first accumulator 22, multiplier 25, and second accumulator 23, respectively. Then, to prepare the filtering operation for the next codeword, the codeword $D_{-2}$ is written into the RAM 11. Thus, with this embodiment, the RAMs 11 and 12 are alternately used to arrange the codewords.

Each of the ROMs 13 and 14 may be composed of an ROM of the type illustrated in Figure 2 of the U.S. Patent No. 4,215,415, while each of the RAMs 11 and 12 may be composed of a memory similar to the A store shown in Figure 3 of the U.S. Patent No. 3,903,371. Further, the selectors 15 to 19 may be made up of multiplexers referred to in "Signetics Logic—TTL DATA Manual", May 1978, Signetics Corporation, pp. 232—234.

Although, in the embodiments, the coefficient differences are taken once or twice depending on equations (6) through (10), the frequency to be taken out may be much larger.

As discussed above, the present invention greatly contributes to reducing the number of multiplications by the use of the novel hardware.

**Claims**

1. A non-recursive digital filter having predetermined N filter coefficients $h_i$ (i=0 to N−1) to perform

$$y(n)= \sum_{i=0}^{N-1} h_i x(n-i) = \sum_{i,j=0}^{N-1} \text{sign}(h_i)h^*_j x^*(n-j) = \sum_{j=0}^{N-1} h^*_j \widetilde{x^*}(n-j) = \sum_{j=0}^{N-1} \Delta_j u(n-j)$$

in response to a sequence $x(n-i)$ of N consecutive binary coded words, where $h^*_j$ represent the absolute values of the coefficients $h_i$ arranged in the order of magnitude so that each index j is in one-to-one correspondence to a specific index i; $x^*(n-j)$ represent $x(n-i)$ corresponding to $h^*_j$; sign $(h_i)$ represent the polarities of $h_i$; $\Delta_j$ represent differences between adjoining coefficients $h^*_j$; $\widetilde{x^*}(n-j)$ represent the products of sign $(h_i)$ and the corresponding $x^*(n-j)$; and

$$u(n-j)= \sum_{k=j}^{N-1} \widetilde{x^*}(n-k),$$

said filter comprising:
a) arranging means (11, 12, 13, 15—19, 20, 24) for arranging said sequence $x(n-i)$ corresponding to the coefficients $h^*_j$ to obtain $x^*(n-j)$;
b) first means (21) for obtaining the product of each of the outputs $x^*(n-j)$ given from the arranging means (11, 12, 13, 15—19, 20, 24) and the corresponding polarity of each of the coefficients $h_i$;
c) second means (22) for accumulating the outputs $\widetilde{x^*}(n-j)$ given from said first means (21) to obtain $u(n-j)$ and coefficient generating means for producing said differences $\Delta_j$;
d) third means (25) for multiplying the outputs $u(n-j)$ supplied from said second means (22) by said differences $\Delta_j$; and
e) fourth means (23) for accumulating outputs $\Delta_j u(n-j)$ given from said third means (25).

2. A non-recursive digital filter having predetermined N filter coefficients $h_i$(i=0 to N−1) to perform

$$y(n)= \sum_{i=0}^{N-1} h_i x(n-i) = \sum_{i,j=0}^{N-1} \text{sign}(h_i)h^*j x^*(n-j) = \sum_{j=0}^{N-1} h^*_j \widetilde{x^*}(n-j) = \sum_{j=0}^{N=1} \Delta_j u(n-j) = \sum_{l=0}^{N-1} C_l u(n-l)$$

in response to a sequence $x(n-i)$ of N consecutive binary coded words, where $h^*_j$ represent the absolute values of the coefficients $h_i$ arranged in the order of magnitude so that each index j is in one-to-one correspondence to a specific index i; $x^*(n-j)$ represent $x(n-i)$ corresponding to $h^*_j$; sign$(h_i)$ represent the polarities of $h_i$; $\Delta_j$ represent differences between adjoining coefficients $h^*_j$; $\widetilde{x^*}(n-j)$ represent the products of sign$(h_i)$ and the corresponding $x^*(n-j)$;

$$u(n-j)= \sum_{k=j}^{N-1} \widetilde{x^*}(n-k);$$

$C_l$ represent differences between adjoining coefficients $\Delta_l^*$ obtained by arranging $\Delta_j$ in the order of magnitude;

$$u(n-l)= \sum_{k=l}^{N-1} u^*(n-k);$$

and $u^*(n-l)$ represent $u(n-j)$ corresponding to $\Delta^*_l$, said filter comprising:
a) first arranging means (5) for arranging said sequence $x(n-i)$ corresponding to the coefficients $h^*_j$ to obtain $x^*(n-j)$;
b) first arithmetic means (6) for obtaining the product each of outputs $x^*(n-j)$ given from the first arranging means (5) and the corresponding polarity of each of the coefficients $h_i$;
c) first adding means (7) for accumulating the outputs $\widetilde{x^*}(n-j)$ given from the first arithmetic means (6) to obtain $u(n-j)$;
d) second arranging means (8) for arranging the outputs $u(n-j)$ supplied from said first adding means (7) corresponding to the coefficients $\Delta^*_l$ to produce $u^*(n-l)$;
e) second adding means (9) for accumulating the outputs fed from the second arranging means (8) to obtain $u(n-l)$ and coefficient generating means for producing said coefficients $C_l$;

f) second arithmetic means (10) for multiplying the outputs u(n−l) supplied from the second adding means (9) by said coefficients $C_l$; and

g) third adding means (4) for accumulating the outputs $C_l u(n-l)$ given from the second arithmetic means (10).

**Patentansprüche**

1. Nicht-rekursives digitales Filter mit N vorgegebenen Filterkoeffizienten $h_i$ (i=0 bis N−1) zum Durchführen von

$$y(n)= \sum_{i=0}^{N-1} h_i x(n-i)= \sum_{i,j=0}^{N-1} \text{sign}(h_i)h^*_j x^*(n-j)= \sum_{j=0}^{N-1} h^*_j \widetilde{x}^*(n-j) = \sum_{j=0}^{N-1} \Delta_j u(n-j)$$

als Antwort auf eine Sequenz x(n−i) von N konsekutiven binären codierten Wörtern, wobei $h^*_j$ die Absolutwerte der nach ihrer Größe geordneten Koeffizienten $h_i$ darstellt, so daß jeder Index j in Eins-zu-Eins-Beziehung zu einem bestimmten Index i steht; $x^*(n-j)$ die $h^*_j$ entsprechenden x(n−i) darstellt; sign($h_i$) die Polaritäten von $h_i$ darstellt; $\Delta_j$ Differenzen zwischen benachbarten Koeffizienten $h^*_j$ darstellt, $\widetilde{x}^*(n-j)$ die Produkte von sign($h_i$) und dem entsprechenden $x^*(n-j)$ darstellt; und

$$u(n-j)= \sum_{k=j}^{N-1} \widetilde{x}^*(n-k),$$

wobei das Filter aufweist:

a) eine Ordnungseinrichtung (11, 12, 13, 15—19, 20, 24) zum Ordnen der Sequenz x(n−i) entsprechend den Koeffizienten $h^*_j$ zum Erhalten von $x^*(n-j)$;

b) eine erste Einrichtung (21) zum Erhalten des Produkts aus jedem der von der Ordnungseinrichtung (11, 12, 13, 15—19, 20, 24) gegebenen Ausgangssignale $x^*(n-j)$ und der entsprechenden Polarität jedes der Koeffizienten $h_i$;

c) eine zweite Einrichtung (22) zum Akkumulieren der von der ersten Einrichtung (21) gegebenen Ausgangssignale $\widetilde{x}^*(n-j)$ zum Erhalten von u(n−j) und eine Koeffizientenerzeugungseinrichtung zum Erzeugen der Differenzen $\Delta_j$;

d) eine dritte Einrichtung (25) zum Multiplizieren der von der zweiten Einrichtung (22) gelieferten Ausgangssignale u(n−j) mit den Differenzen $\Delta_j$; und

e) eine vierte Einrichtung (23) zum Akkumulieren der von der dritten Einrichtung (25) gegebenen Ausgangssignale $\Delta_j u(n-j)$.

2. Nicht-rekursives digitales Filter mit N vorgegebenen Filterkoeffizienten $h_i$ (i=0 bis N−1) zum Durchführen von

$$y(n)= \sum_{i=0}^{N-1} h_i x(n-i)= \sum_{i,j=0}^{N-1} \text{sign}(h_i)h^*_j x^*(n-j)= \sum_{j=0}^{N-1} h^*_j \widetilde{x}^*(n-j) = \sum_{j=0}^{N=1} \Delta_j u(n-j)= \sum_{l=0}^{N-1} C_l u(n-l)$$

als Antwort auf eine Sequenz x(n−i) von N konsekutiven binären codierten Wörtern, wobei $h^*_j$ die Absolutwerte der nach ihrer Größe geordneten Koeffizienten $h_i$ darstellt, so daß jeder Index j in Eins-zu-Eins-Beziehung zu einem bestimmten Index i steht; $x^*(n-j)$ die $h^*_j$ entsprechenden x(n−i) darstellt; sign($h_i$) die Polaritäten von $h_i$ darstellt; $\Delta_j$ Differezen zwischen benachbarten Koeffizienten $h^*_j$ darstellt, $\widetilde{x}^*(n-j)$ die Produkte von sign($h_i$) und dem entsprechenden $x^*(n-j)$ darstellt;

$$u(n-j)= \sum_{k=j}^{N-1} \widetilde{x}^*(n-k),$$

$C_l$ Differenzen zwischen durch Ordnen der $\Delta_j$ nach ihrer Größe erhaltenen benachbarten Koeffizienten $D^*_l$ darstellt;

$$u(n-l)= \sum_{k=l}^{N-1} u^*(n-k);$$

und $u^*(n-l)$ die $\Delta_l^*$ entsprechenden u(n−j) darstellt, wobei das Filter aufweist:

a) eine erste Ordnungseinrichtung (5) zum Ordnen der den Koeffizienten $h^*_j$ entsprechenden Sequenz x(n−i) zum Erhalten von $x^*(n-j)$;

b) eine erste Recheneinrichtung (6) zum Erhalten des Produkts jedes der von der ersten Ordnungseinrichtung (5) erhaltenen Ausgangssignale $x^*(n-j)$ und der entsprechenden Polarität jedes der Koeffizienten $h_i$;

c) eine erste Addiereinrichtung (7) zum Akkumulieren der von der ersten Recheneinrichtung (6) gegebenen Ausgangssignale $\widetilde{x}^*(n-j)$ zum Erhalten von $u(n-j)$;

d) eine zweite Ordnungseinrichtung (8) zum Ordnen der von der ersten Addiereinrichtung (7) gelieferten Ausgangssignale $u(n-j)$ entsprechend den Koeffizienten $\Delta_i^*$ zum Erzeugen von $u^*(n-l)$;

e) eine zweite Addiereinrichtung (9) zum Akkumulieren der von der zweiten Ordnungseinrichtung (8) zugeführten Ausgangssignale zum Erhalten von $u(n-l)$ und eine Koeffizienten-Erzeugungseinrichtung zum Erzeugen der Koeffizienten $C_l$;

f) eine zweite Recheneinrichtung (10) zum Multiplizieren der von der zweiten Addiereinrichtung (9) gelierferten Ausgangssignale $u(n-l)$ mit den Koeffizienten $C_l$; und

g) eine dritte Addiereinrichtung (4) zum Akkumulieren der von der zweiten Recheneinrichtung (10) gegebenen Ausgangssignale $C_l u(n-l)$.

**Revendications**

1. Filtre numérique non récursif ayant N coefficients de filtre prédéterminés $h_i (i=0$ à $N-1)$ pour exécuter

$$y(n)= \sum_{i=0}^{N-1} h_i x(n-i)= \sum_{i,j=0}^{N-1} sign(h_i)h_j^* x^*(n-j) = \sum_{j=0}^{N-1} h_j^* \widetilde{x}^*(n-j)= \sum_{j=0}^{N-1} \Delta_j u(n-j)$$

en réponse à une séquence $x(n-i)$ de N mots consécutifs codés en binaire, où $h_j^*$ représente les valeurs absolues des coefficients $h_i$ ordonnés dans l'ordre de grandeur de sorte que chaque indice j est dans une correspondance bi-univoque avec un indice spécifique i; $x^*(n-j)$ représentent $x(n-i)$ correspondant à $h_j^*$; les signes $(h_i)$ représentent les polarités de $h_i$; $\Delta_j$ représentent les différence entre coefficients contigus $h_j^*$; $\widetilde{x}^*(n-j)$ représentent les produits de signes $(h_i)$ et des $x^*(n-j)$ correspondants et

$$u(n-j)= \sum_{k=j}^{N-1} \widetilde{x}^*(n-k),$$

le filtre comprenant:

a) un moyen d'ordonnance (11, 12, 13, 15—19, 20, 24) pour ordonner la séquence $x(n-i)$ correspondant aux coefficients $h_j^*$ afin d'obtenir $x^*(n-j)$;

b) un premier moyen (21) pour obtenir le produit de chacune des sorties $x^*(n-j)$ provenant du moyen d'ordonnance (11, 12, 13, 15—19, 20, 24) et de la polarité correspondante de chacun des coefficients $h_i$;

c) un second moyen (22) pour totaliser les sorties $\widetilde{x}^*(n-j)$ données par le premier moyen (21) pour obtenir $u(n-j)$ et un moyen de génération de coefficient pour produire les différences $\Delta_j$;

d) un troisième moyen (25) pour multiplier les sorties $u(n-j)$ fournies par le second moyen (22) par les différences $\Delta_j$; et

e) un quatrième moyen (23) pour totaliser les sorties $\Delta_j u(n-j)$ données par le troisième moyen (25).

2. Filtre numérique non récursif comportant N coefficients de filtre prédéterminés $h_i (i=0$ à $N-1)$ pour exécuter:

$$y(n)= \sum_{i=0}^{N-1} h_i x(n-i)= \sum_{i,j=0}^{N-1} sign(h_i)h_j^* x^*(n-j) = \sum_{j=0}^{N-1} h_j^* \widetilde{x}^*(n-j)= \sum_{j=0}^{N=1} \Delta_j u(n-j)= \sum_{l=0}^{N-1} C_l u(n-l)$$

en réponse à une séquence $x(n-i)$ de N mots consécutifs codés en binaire, où $h_j^*$ représentent les valeurs absolues des coefficients $h_i$ ordonnés dans l'ordre de grandeur de sorte que chaque indice j est dans une correspondance biunivoque avec un indice spécifique i; $x^*(n-j)$ représentent $x(n-i)$ correspondant à $h_j^*$; les signes $(h_i)$ représentent les polarités de $h_i$; $\Delta_j$ représentent les différences entre coefficients contigus $h_j^*$; $\widetilde{x}^*(n-j)$ représentent les produits des signes $(h_i)$ et le $x^*(n-j)$ correspondant;

$$u(n-j)= \sum_{k=j}^{N-1} \widetilde{x}^*(n-k);$$

$C_l$ représentent les différences entre coefficients contigus $\Delta_l^*$ obtenues en ordonnant $\Delta_j$ dans l'ordre de grandeur;

$$u(n-l) = \sum_{k=l}^{N-1} u^*(n-k);$$

et $u^*(n-l)$ représentent $u(n-j)$ correspondant à $\Delta_l^*$, le filtre comprenant:

a) un premier moyen d'ordonnance (5) pour ordonner la séquence $x(n-i)$ correspondant aux coefficients $h_j^*$ pour obtenir $x^*(n-j)$;

b) un premier moyen arithmétique (6) pour obtenir le produit de chacune des sorties $x^*(n-j)$ données par le premier moyen d'ordonnance (5) et la polarité correspondante de chacun des coefficients $h_i$;

c) un premier moyen d'addition (7) pour totaliser les sorties $\widetilde{x}^*(n-j)$ données par le premier moyen arithmétique (6) pour obtenir $u(n-j)$;

d) un second moyen d'ordonnance (8) pour ordonner les sorties $u(n-j)$ fournies par le premier moyen d'addition (7) correspondant aux coefficients $\Delta_l^*$ et produire $u^*(n-l)$;

e) un second moyen d'addition (9) pour totaliser les sorties provenant du second moyen d'ordonnance (8) pour obtenir $u(n-l)$ et un moyen de génération de coefficient pour produire le coefficient $C_i$;

f) un second moyen arithmétique (10) pour multiplier les sorties $u(n-l)$ fournies par le second moyen d'addition (9) par les coefficients $C_i$; et

g) un troisième moyen d'addition (4) pour totaliser les sorties $C_i u(n-l)$ données par le second moyen arithmétique (10).

# Fig. 1

Fig. 2

0 034 241

| Tap Number of Delay Elements | $h_i$ Original Coefficients | $h_j^*$ Rearranged Coefficients in Order of $h_i$ value | $\triangle_j$ First Difference Coefficients |
|---|---|---|---|
| 0 | $h_0 = 0.03125$ | $h_0^* = 0.03125$ | $\triangle_0 = 0.03125$ |
| 1 | $h_1 = -0.03125$ | $h_1^* = 0.03125$ | $\triangle_1 = 0.0$ |
| 2 | $h_2 = -0.15625$ | $h_2^* = 0.03125$ | $\triangle_2 = 0.0$ |
| 3 | $h_3 = 0.0625$ | $h_3^* = 0.03125$ | $\triangle_3 = 0.0$ |
| 4 | $h_4 = 0.5$ | $h_4^* = 0.0625$ | $\triangle_4 = 0.03125$ |
| 5 | $h_5 = 0.5$ | $h_5^* = 0.0625$ | $\triangle_5 = 0.0$ |
| 6 | $h_6 = 0.0625$ | $h_6^* = 0.15625$ | $\triangle_6 = 0.09375$ |
| 7 | $h_7 = -0.15625$ | $h_7^* = 0.15625$ | $\triangle_7 = 0.0$ |
| 8 | $h_8 = -0.03125$ | $h_8^* = 0.5$ | $\triangle_8 = 0.34375$ |
| 9 | $h_9 = 0.03125$ | $h_9^* = 0.5$ | $\triangle_9 = 0.0$ |

Fig. 3

| $\Delta_j$ (j=0~9) | $\Delta_l^*$ (l=0~9) | $c_l$ (l=0~9) |
|---|---|---|
| First Difference Coefficients | Rearranged Coefficients in Order of $\Delta_j$ value | Second Difference Coefficients |
| $\Delta_0 = 0.03125$ | $\Delta_0^* = 0.0$ | $c_0 = 0.0$ |
| $\Delta_1 = 0.0$ | $\Delta_1^* = 0.0$ | $c_1 = 0.0$ |
| $\Delta_2 = 0.0$ | $\Delta_2^* = 0.0$ | $c_2 = 0.0$ |
| $\Delta_3 = 0.0$ | $\Delta_3^* = 0.0$ | $c_3 = 0.0$ |
| $\Delta_4 = 0.03125$ | $\Delta_4^* = 0.0$ | $c_4 = 0.0$ |
| $\Delta_5 = 0.0$ | $\Delta_5^* = 0.0$ | $c_5 = 0.0$ |
| $\Delta_6 = 0.09375$ | $\Delta_6^* = 0.03125$ | $c_6 = 0.03125$ |
| $\Delta_7 = 0.0$ | $\Delta_7^* = 0.03125$ | $c_7 = 0.0$ |
| $\Delta_8 = 0.34375$ | $\Delta_8^* = 0.09375$ | $c_8 = 0.0625$ |
| $\Delta_9 = 0.0$ | $\Delta_9^* = 0.34375$ | $c_9 = 0.25$ |

Fig. 4

0 034 241

Fig. 5

0 034 241

Fig. 6